# EUROPEAN PATENT SPECIFICATION

(11) **EP 0 997 939 B1**
(45) Date of publication and mention of the grant of the patent: **07.09.2005**
(21) Application number: 99308579.4
(22) Date of filing: 29.10.1999
(51) Int. Cl.: H01L 23/49, H01L 21/56, H01L 23/31

(54) **Semiconductor device comprising a lead wire**
Halbleiteranordnung mit einem Leitungsdraht
Dispositif semiconducteur comprenant un fil conducteur

(30) Priority: 30.10.1998 JP 31083498; 20.08.1999 JP 23438099
(43) Date of publication of application: 03.05.2000
(73) Proprietor: SHINKO ELECTRIC INDUSTRIES CO. LTD., Nagano 380-0921 (JP)
(72) Inventor: Higashi, Mitsutoshi, Shinko Electric Ind. Co. Ltd., Nagano-shi, Nagano 380-0921 (JP); Sakaguchi, Hideaki, Shinko Electric Ind. Co. Ltd., Nagano-shi, Nagano 380-0921 (JP); Imai, Kazunari, Shinko Electric Ind. Co. Ltd., Nagano-shi, Nagano 380-0921 (JP); Kyozuka, Masahiro, Shinko Electric Ind. Co. Ltd., Nagano-shi, Nagano 380-0921 (JP); Shimizu, Mitsuharu, Shinko Electric Ind. Co. Ltd., Nagano-shi, Nagano 380-0921 (JP)
(74) Representative: Rackham, Stephen Neil

(56) References cited:
- WO-A-95/14314
- US-A- 5 495 667
- PATENT ABSTRACTS OF JAPAN vol. 009, no. 325 (E-368), 20 December 1985 (1985-12-20) & JP 60 157245 A (MITSUBISHI DENKI KK), 17 August 1985 (1985-08-17)
- PATENT ABSTRACTS OF JAPAN vol. 011, no. 244 (E-530), 8 August 1987 (1987-08-08) & JP 62 057223 A (SEIKO EPSON CORP), 12 March 1987 (1987-03-12)
- PATENT ABSTRACTS OF JAPAN vol. 016, no. 478 (E-1274), 5 October 1992 (1992-10-05) & JP 04 171946 A (FUJITSU LTD;OTHERS: 01), 19 June 1992 (1992-06-19)
- PATENT ABSTRACTS OF JAPAN vol. 1995, no. 05, 30 June 1995 (1995-06-30) & JP 07 045751 A (NIPPON CHEMICON CORP), 14 February 1995 (1995-02-14)

## Description

This invention relates to a semiconductor device and a method of fabricating the device.

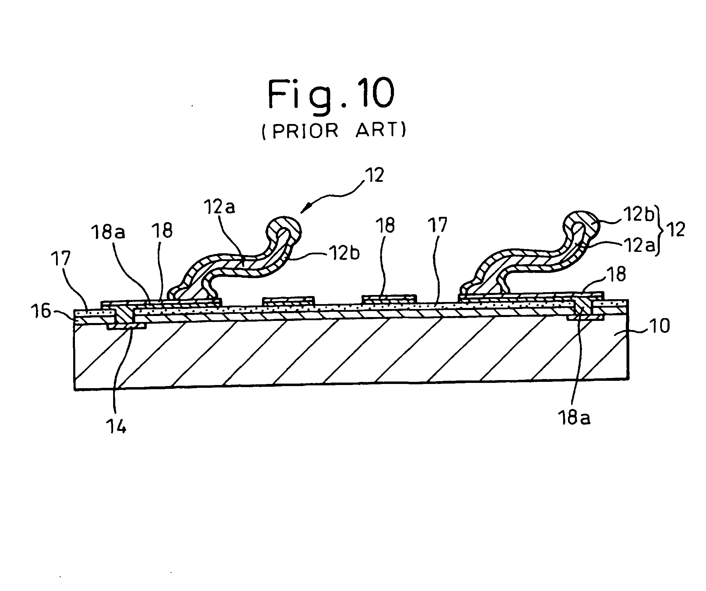

A semiconductor device having substantially the same size as a semiconductor chip, as proposed in the past, is shown in Fig. 10. In this semiconductor device, wires used as external connection terminals 12 are bent and are attached to an electrode terminal formation surface of the semiconductor chip 10. Fig. 10 is a partial enlarged view of the semiconductor device. Reference numeral 14 denotes the electrode terminals that are disposed on the surface of the semiconductor element 10. Reference numeral 16 denotes a passivation film, reference numeral 17 denotes an electrical insulating layer and reference numeral 18 denotes re-wiring or secondary-wiring portions. Each re-wiring portion 18 is connected at one end thereof to the electrode terminal. The other end of the re-wiring portion 18 is shaped into a pad portion for connecting the external connection terminal 12. The external connection terminal 12 is fabricated by applying a protection plating 12b of a nickel alloy, or the like, to the outer surface of a gold wire 12a.

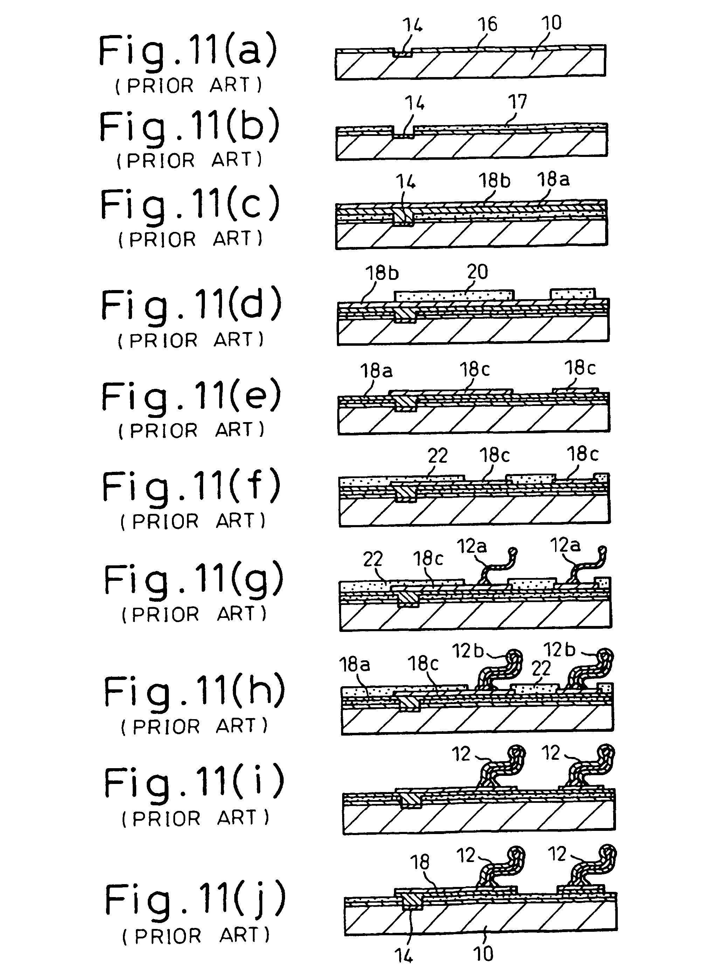

Figs. 11(a) to 11(j) show a fabrication process for forming the external connection terminal 12 using the wire on the electrode terminal formation surface of the semiconductor chip 10.

Fig. 11(a) shows the state where the electrode terminal formation surface of the semiconductor element 10 is covered with the passivation film 16 while the electrode terminal 14 is exposed. Fig. 11(b) shows the step of forming the electrical insulating layer 17. The electrical insulating layer 17 is formed by covering the electrode terminal formation surface with a resin material having an electrical insulating property such as a polyimide resin, and the portion, where the electrode terminal 14 is formed, is etched so as to expose the electrode terminal 14. Fig. 11(c) shows the step of forming the re-wiring portion 18 on the electrode terminal formation surface. First, a titanium-tungsten alloy is sputtered to form a metal layer 18a, and then a gold layer 18b is formed by sputtering gold or plating with gold. The metal layer 18a and the gold layer 18b are laminated, and the metal layer 18a is electrically connected to the electrode terminal 14.

Fig. 11(d) shows the state where a resist pattern 20 is formed for etching the gold layer 18b. The resist pattern 20 is patterned so as to cover the portions where the gold layer 18b is left during etching. Fig. 11(e) shows the state where a predetermined gold pattern 18c is formed by etching the gold layer 18b.

Fig. 11(f) shows the state where the gold pattern 18c is covered with a resist 22 in such a fashion as to leave the bonding portions, to which the gold wire is to be bonded, in order to bond the gold wire to the gold pattern 18c by wire-bonding. Fig. 11(g) shows the state where the gold wire 12a is bonded to the bonding portions of the gold pattern 18c by utilizing a wire bonding method. The gold wire 12a is bent into an L-shape, and the end portion is cut and bent upright. Fig. 11(h) shows the process for applying the protection plating 12b such as nickel alloy plating to the surface of the gold wire 12a. This protection plating 12b can be applied by electrolytic plating using the gold layer 18a as a plating feeder line.

Fig. 11(i) shows the state where the resist 22 is removed. The metal layer 18a is etched in this state to form the re-wiring portions 18 as an independent pattern, as shown in Fig. 11(j). In this process for forming the re-wiring portion 18 by etching the metal layer 18a, etching is conducted by using an etching solution that etches the metal layer 18a but does not corrode the gold layer 18b. As a result, the re-wiring portions 18 having an independent wiring pattern are formed on the electrode terminal formation surface of the semiconductor element 10, and a semiconductor device can be obtained after the external connection terminals 12 are implanted into the re-wiring portions 18.

The gold wire 12a is bent and shaped into an L-shape, as described above, so that the external connection terminal 12 has flexibility and predetermined buffer property. This semiconductor device is packaged while the distal end portion of each external connection terminal 12 is bonded to a packaging substrate. Therefore, when the external connection terminal 12 has the buffer property, the problems of thermal stress occurring between the packaging substrate and the semiconductor device when the semiconductor device is packaged, and the like, can be avoided.

However, the semiconductor device having the external connection terminals 12 formed of the gold wire 12a is not free from the problems that a solder used for bonding the distal end portion of each external connection terminal 12 to the packaging substrate adheres to the surface of the re-wiring portion 18 and invites a short-circuit, and migration develops between the lead wires due to moisture absorption. These problems occur because the external connection terminals 12 and the re-wiring portions 18 are so formed as to be exposed on the electrode terminal formation surface and the solder is likely to creep up during packaging.

In order to solve these problems, the present invention is directed to provide a semiconductor device that has external connection terminals formed by bending a wire and is electrically connected to electrodes formed on an electrode formation surface of a semiconductor element, wherein the external connection terminals have a predetermined buffer property, can appropriately avoid thermal stress at the time of packaging, and can reliably eliminate the problem of electrical short-circuit of re-wiring portions during packaging, and handling of the semiconductor device becomes easier during packaging. The present invention is directed to provide also a method fabricating such a semiconductor device.

According to the present invention, there is provided a semiconductor device comprising:
a semiconductor element having an electrode formation surface on which at least one electrode terminal and a re-wiring portion are formed, said re-wiring electrically connected to said electrode terminal;
an external terminal made of wire having a base end connected to said re-wiring portion and a distal end extending therefrom; and
electrically insulating resin covering said electrode formation surface, at least said one electrode terminal, said re-wiring portion and a part of said external terminal in such a manner that at least said distal end of the external terminal is exposed out of said insulating resin.

The external terminal may be connected to the re-wiring portion by wire-bonding and has a substantially L-shape at an intermediate position thereof between the base and distal ends thereof.

According to another aspect of the present invention, there is provided a process for fabricating a semiconductor device comprising a semiconductor element having an electrode formation surface on which at least one electrode terminal and a re-wiring portion are formed, said re-wiring portion electrically connected to said electrode terminal; said process comprising the following steps of:
bonding one end of a wire to said rewiring portion to form an external connecting terminal in such a manner that said external connecting terminal extends from and is supported by said re-wiring portion;
coating said electrode formation surface, at least said one electrode terminal, said re-wiring portion and an outer surface of said external connecting terminal with an electrically insulating resin; and
removing a part of said electrically insulating resin from a distal end of said external connecting terminal to expose the same from the insulating resin.

During the bonding process, the one end of the wire mary be first bonded to the re-wiring portion and then a substantially L-shape portion may be formed at an intermediate position thereof.

The electrode formation surface may be coated with electrically insulating resin by spin-coating or spray-coating.

The electrode formation surface may be coated with electrically insulating resin by dipping the semiconductor element together with the external connecting terminal in a liquid insulating resin.

The electrode formation surface of the semiconductor element may be coated with an electrically insulating resin to such a depth that the external connecting terminal is buried within the insulating resin; and then a part of the electrically insulating resin may be removed so that the distal end of the external connecting terminal is exposed from the insulating resin.

A part of the electrically insulating resin may be removed by etching.

A part of the electrically insulating resin may be removed by dipping the tip end of the external connecting terminal in a peeling solution.

Particular embodiments in accordance with this invention will now be described with reference to the accompanying drawings; in which:
Fig. 1 is a sectional view showing a structure of a semiconductor device according to an embodiment of the present invention;
Figs. 2(a) and 2(b) are explanatory views useful for explaining a method of fabricating the semiconductor device shown in Fig. 1;
Fig. 3 is a sectional view showing a structure of a semiconductor device according to another embodiment of the present invention;
Fig. 4 is a sectional view showing a structure of a semiconductor device according to still another embodiment of the present invention;
Fig. 5 is a sectional view showing a structure of a semiconductor device according to still another embodiment of the present invention;
Figs. 6(a) to 6(c) and Figs. 7(a) and 7(b) are explanatory views, each being useful for explaining a method of fabricating the semiconductor device shown in Fig. 5;
Figs. 8(a) and 8(b) are explanatory views, each being useful for explaining creep-up of solder when a semiconductor device is packaged;
Figs. 9(a) and 9(b) are explanatory views, each being useful for explaining a method of fabricating a semiconductor device according to still another embodiment of the present invention;
Fig. 10 is a sectional view showing a structure of a semiconductor device known in the prior art; and
Fig. 11(a) to 11(j) are explanatory views useful for explaining a method of fabricating a semiconductor device known in the prior art.

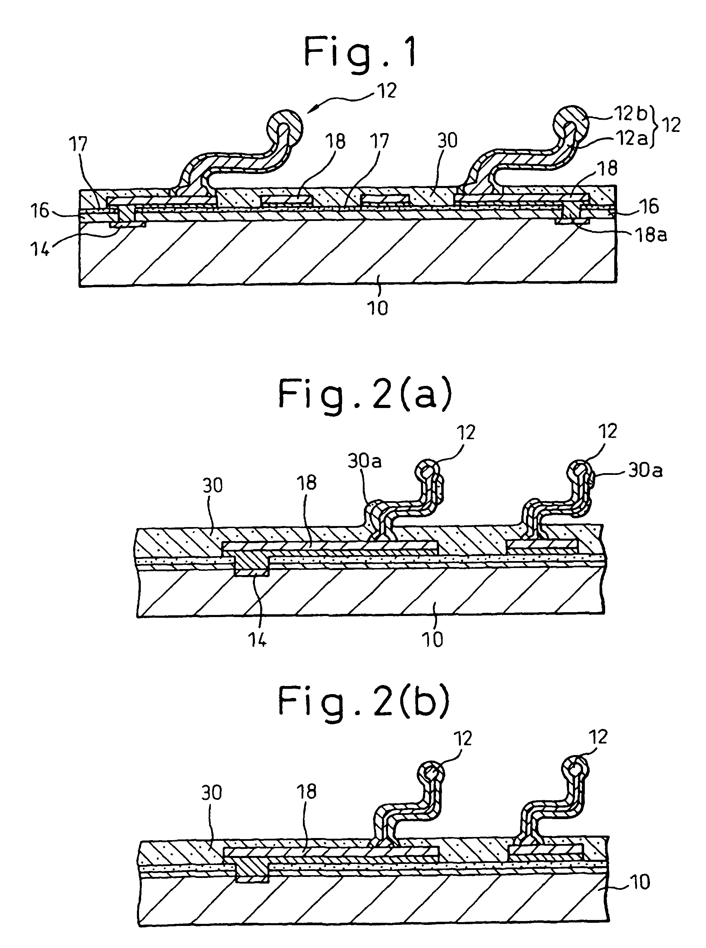

Fig. 1 shows a semiconductor device according to one embodiment of the present invention. In the semiconductor device according to this embodiment, each external connection terminal 12 is fabricated by bending a gold wire 12a into an L shape as viewed in the side view, and is connected to or secondary-wiring a re-wiring portion 18 formed on an electrode terminal formation surface of a semiconductor element 10, in the same way as the semiconductor device shown in Fig. 10. Though the external connection terminal 12 has the L-shape as viewed in the side view in this embodiment, it may have other shapes such as an S-shape or a curve shape such as an arcuated shape. The re-wiring portion 18 is formed on the surface of an electrically insulating layer 17 covering a passivation film 16 while one of the ends thereof is connected to an electrode terminal 14. Reference numeral 18a denotes a metal layer connected electrically to the electrode terminal 14.

The semiconductor device of this embodiment has a structure which is substantially the same as that of the conventional semiconductor device shown in Fig. 10 with the exception that the re-wiring portion 18 formed on the electrode terminal formation surface is covered with an insulating resin 30. The external connection terminal 12 is exposed from the base, but the entire surface of the electrode terminal formation surface is covered with the insulating resin 30. Because the electrode terminal formation surface is covered with the insulating resin 30 in this way, the re-wiring portion 18 is protected without being exposed to the outside. Consequently, it becomes possible to prevent the problems that solder adheres to the re-wiring portion 18 and invites an electrical short-circuit between lead wires and that migration occurs between adjacent re-wiring portions 18. As a result, the semiconductor device according to this embodiment can be packaged reliably without causing the electrical short-circuit between the lead wires and can easily be handled during packaging.

A method of fabricating the semiconductor device having such a structure that the electrode terminal formation surface of the semiconductor device is covered with the insulating resin 30 is exactly the same as the fabrication method of the semiconductor device according to the prior art shown in Fig. 11 up to the fabrication step (j). After this process step (j), the electrode terminal formation surface is coated with a resin material having an electrically insulating property and then curing is done (Fig. 2(a)). Next, the resin material 30a adhering to the outer surface of the external connection terminal 12 during coating is removed by etching (Fig. 2(b)), providing the semiconductor device. The method of coating the electrode terminal formation surface of the semiconductor element 10 with the resin material includes spin coating, spraying, and so forth.

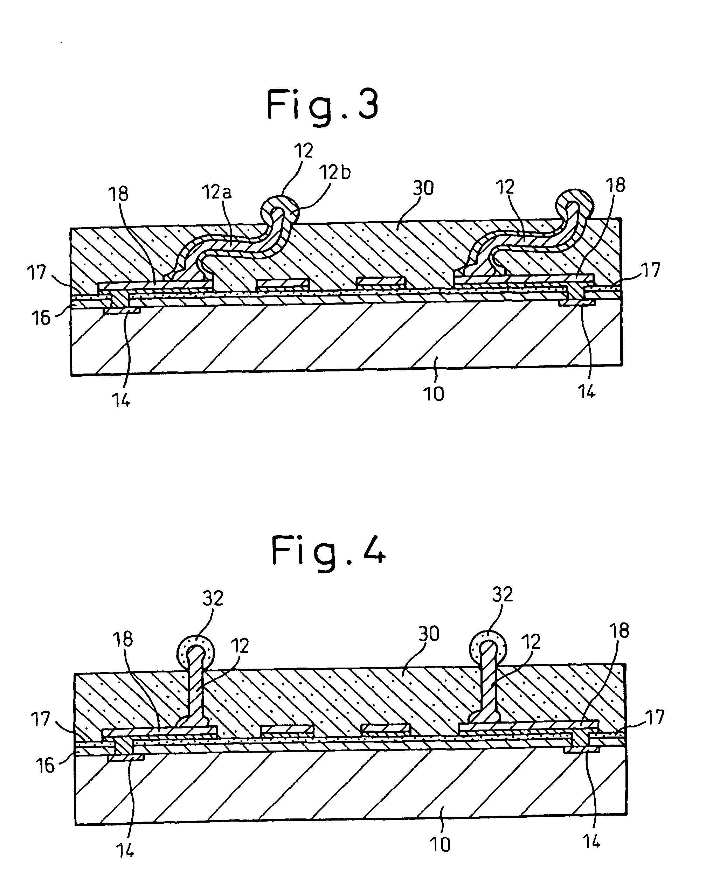

The semiconductor device according to this embodiment is of the type wherein the electrode terminal formation surface of the semiconductor element 10 is covered with the insulating resin 30 and the external connection terminal 12 is exposed from the base portion. In contrast, the semiconductor devices of the embodiments shown in Figs. 3 and 4 are of the type wherein the electrode terminal formation surface of the semiconductor element 10 is covered relatively thickly with the insulating resin 30 and only the distal end portion of the external connection terminal 12 is exposed from the outer surface of the insulating resin 30.

In the embodiment shown in Fig. 3, the external connection terminal 12 is bent into the L-shaped as viewed in the side view in the same way as in the embodiment described above, and the distal end portion of this external connection terminal 12 is exposed from the outer surface of the insulating resin 30. The external connection terminal 12 has protection plating 12b formed on the outer surface of a gold wire 12a.

In the embodiment shown in Fig. 4, the external connection terminal 12 is shaped in such a fashion as to extend vertically upright from the electrode terminal formation surface. The distal end portion of the external connection terminal 12 protrudes from the outer surface of the insulating resin 30, and a solder bump 32 is formed at the distal end portion of the external connection terminal 12. The solder bump 32 can be formed at the distal end portion of the external connection terminal 12 by printing a solder paste, applying it to the distal end portion of the external connection terminal 12 and re-flowing the solder. In order to bond the bump 32 to the distal end portion of the external connection terminal 12, the external connection terminal 12 is preferably made of the gold wire itself, or a gold wire plated with palladium plating or a gold wire plated with a nickel-cobalt alloy and further with palladium plating, in order to improve its wettability by solder.

In the embodiments shown in Figs. 3 and 4, the external connection terminal 12 is buried in the insulating resin 30. Therefore, these embodiments provide the advantage that the operation for covering the electrode terminal formation surface with the insulating resin 30 becomes relatively easy. When these semiconductor devices are fabricated, the process steps up to the formation of the external connection terminal 12 are the same as those of the prior art method. After the external connection terminal 12 is formed, the entire surface of the electrode terminal formation surface of the semiconductor element 10 is coated with the insulating resin 30 in such a fashion as to bury the external connection terminal 12, and the outer surface of the insulating resin 30 is etched so that the distal end portion of the external connection terminal 12 is exposed from the surface of the insulating resin 30.

When the external connection terminal 12 is buried into the insulating resin 30 with the exception of its distal end as shown in Figs. 3 and 4, an insulating resin 30 having a low elastic modulus is preferably employed so that the thermal stress can be mitigated at the portion of the insulating resin 30 during the packaging operation. A resin material having an elastic modulus of not higher than 1 KPa is suitable for the insulating resin 30, and examples of such a resin include an epoxy resin, an acrylic resin, a silicone resin, and so forth. When the insulating resin 30 having such a low elastic modulus is used, the thermal stress, or the like, during packaging of the semiconductor device can be mitigated effectively. Furthermore, the problem of the electrical short-circuit of wires during packaging can be eliminated, and a semiconductor device which is easy to handle can be provided.

The semiconductor device according to each of the embodiments described above uses the external connection terminal 12 that is formed by applying the protection plating 12b of the nickel-cobalt alloy to the gold wire 12a. When the electrode terminal formation surface of the semiconductor chip 10 is covered with the insulating resin 30 as shown in Figs. 3 and 4, however, it is also possible not to cover the outer surface of the external connection terminal 12 with the protection plating 12b. For, the insulating resin 30 protects the external connection terminal 12.

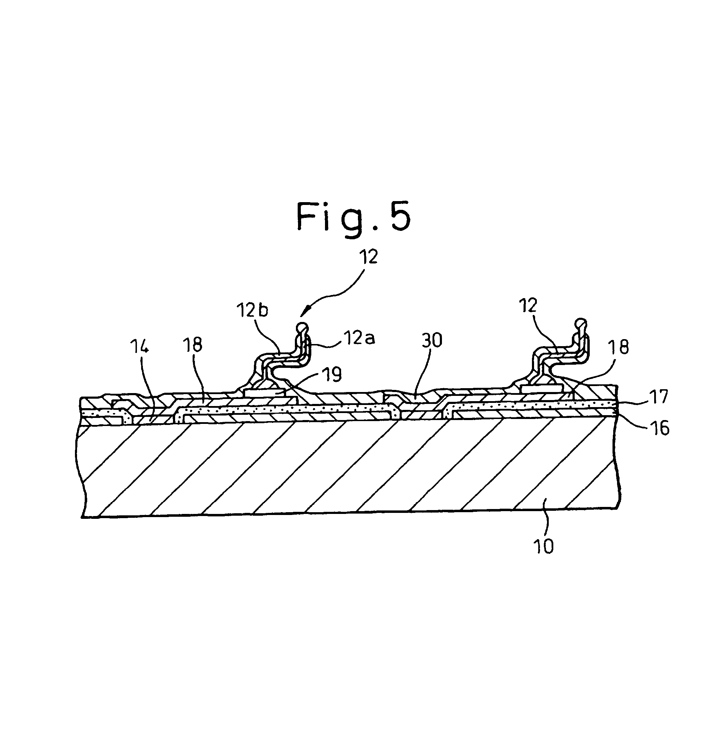

Fig. 5 shows the semiconductor device according to still another embodiment of the present invention. In the semiconductor device according to this embodiment, the electrode terminal formation surface, inclusive of the re-wiring portion 18, is fully covered with the insulating resin 30 having an electrically insulating property. The external connection terminal 12 protruding from the electrode terminal formation surface is covered with the insulating resin 30, with the exception of the distal end portion thereof that is to be connected to the packaging substrate. As the electrode terminal formation surface inclusive of the re-wiring portion 18 is covered with the insulating resin 30, the re-wiring portion 18 is protected from being exposed to the outside. In consequence, the problem that the solder adheres to the re-wiring portion 18 and invites the electrical short-circuit of lead wires during packaging of the semiconductor device can be eliminated, and migration between adjacent lead wires can be prevented, too.

A metal layer 19 is Pd plated layer formed the area to which the gold wire 12a of the re-wiring pattern 18 is bonded. Such a metal layer 19 is not always necessary.

Since the insulating resin 30 covers the outer surface of the gold wire 12a, this embodiment uses a resin having a low elastic modulus and a certain degree of flexibility so that the external connection terminal 12 can have required flexibility under the state where it is covered with the insulating resin 30. A resin material having an elastic modulus of up to 1 KPa can be used appropriately for the insulating resin 30, and preferred examples of each resin are epoxy, or acrylic type resin materials, or a silicone resin. When the outer surface of the gold wire 12a is covered with the insulating resin 30 having low flexibility, the external connection terminal 12 is provided with higher and sufficient flexibility than when the outer surface of the gold wire 12a is covered by the protecting plating 12b as has been made in the prior art devices, and the stress mitigation operation becomes more excellent during packaging.

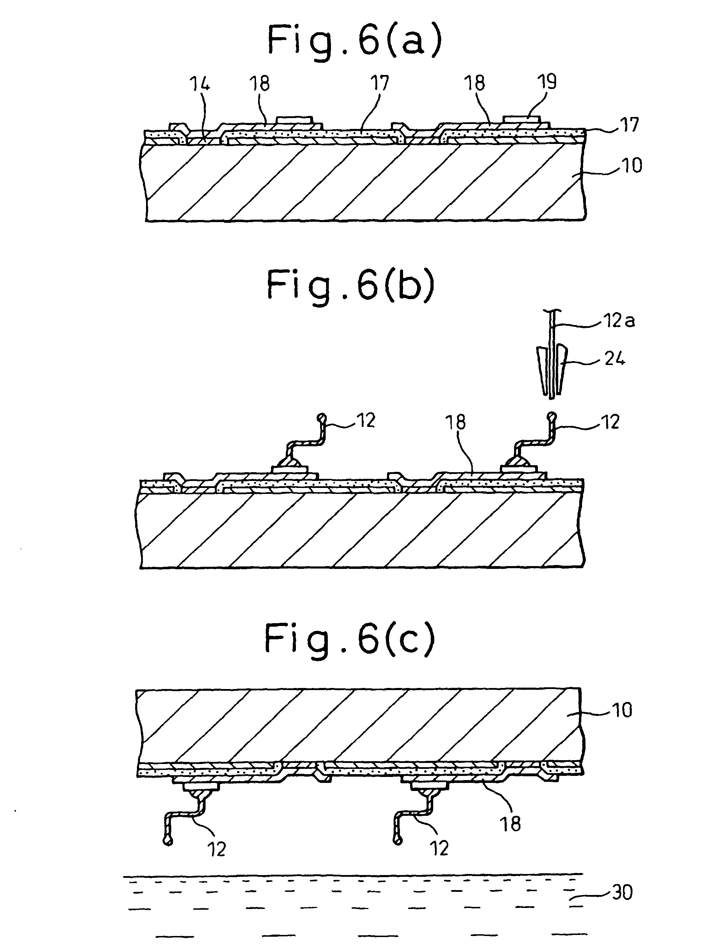

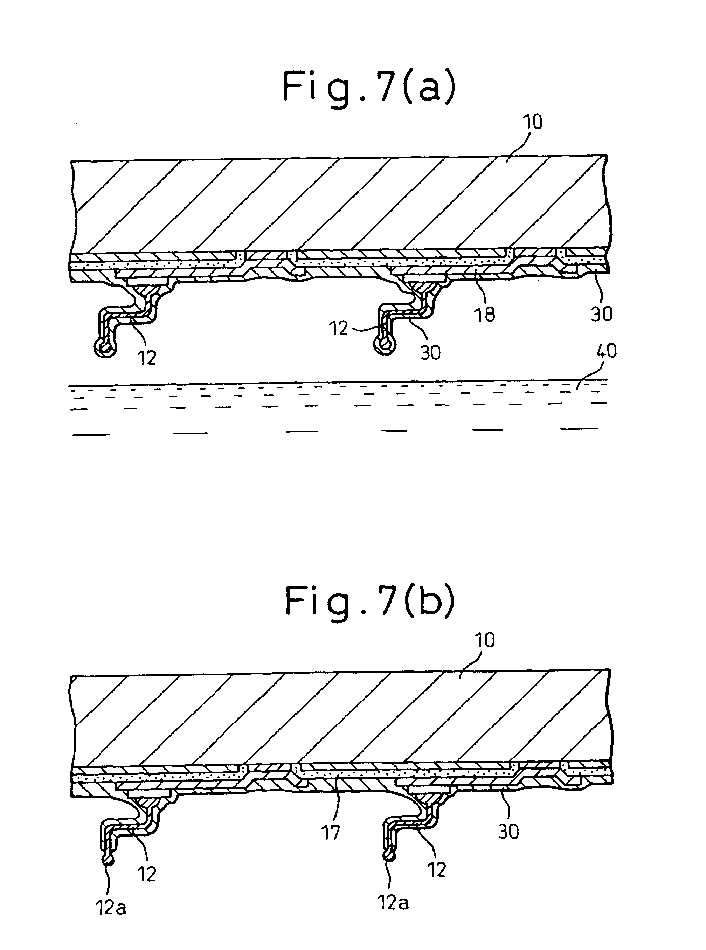

Figs. 6 and 7 show a fabrication process of the semiconductor device of this embodiment. Fig. 6(a) shows the state where the re-wiring portion 18 is formed on the electrode terminal formation surface of the semiconductor element 10. In this embodiment, the protection plating 12b is not applied to the outer surface of the gold wire 12a as the external connection terminal 12. Therefore, the re-wiring portion 18 can be formed by etching the metal layer 18a in the process step (e) in the prior art process shown in Fig. 11. Another method of forming the re-wiring portion 18 comprises the steps of forming a conductor layer by sputtering, or like means, on the surface of the electrical insulation layer 17 formed on the electrode terminal formation surface, forming a resist pattern that covers only the portions at which the re-wiring portions 18 are to be formed on the surface of the conductor layer, and etching the conductor layer with the resist pattern as a mask in such a fashion as to leave the re-wiring portion 18.

Fig. 6(b) shows the state where the external connection terminal 12 is formed by bonding the gold wire 12a to the re-wiring portion 18. The gold wire 12a is first bonded to the re-wiring portion 18 by using a bonding tool 24 for wire bonding of the semiconductor device, and is then bent into the L-shape and into the shape required of the external connection terminal 12 by controlling the movement of the bonding tool 24 as shown in the drawing.

Fig. 6(c) shows the state where the electrode terminal formation surface is dipped into the liquid insulating resin 30 so that the electrode terminal formation surface of the semiconductor element 10 and the outer surface of the external connection terminal 12 can be coated with the insulating resin 30.

Incidentally, it is possible to spray the liquid insulating resin 30 onto the electrode terminal formation surface of the semiconductor element 10 and to cover the entire surface of the electrode terminal formation surface and the external connection terminal 12 with the insulating resin 30, in place of dipping the electrode terminal formation surface of the semiconductor element 10 and the external connection terminal 12 into the liquid insulating resin 30.

Fig. 7(a) shows the state where the electrode terminal formation surface of the semiconductor element 10 and the outer surface of the external connection terminal 12 are covered with the insulating resin 30 by the process step described above. After the electrode terminal formation surface and the surface of the external connection terminal are covered with the insulating resin 30, the insulating resin 30 is cured.

After curing, the distal end portion of the external connection terminal 12 is exposed. To this end, the distal end portion of the external connection terminal 12 is first immersed in a peeling solution 40 as shown in Fig. 7(a) so that the insulating resin 30 covering the distal end portion of the external connection terminal 12 can be dissolved and removed.

Incidentally, it is possible, depending on the kind of the insulating resin 30, to first cover the electrode terminal formation surface and the outer surface of the external connection terminal 12 with the insulating resin 30, then to provisionally cure the insulating resin 30 so as to dissolve and remove the insulating resin 30 of the distal end portion of the external connection terminal 12, and thereafter to conduct real curing. The state where the insulating resin 30 is provisionally cured provides the advantage that the insulating resin 30 can easily be dissolved and removed.

Fig. 7(b) shows the resulting semiconductor device under the state where the distal end portion of the external connection terminal 12 is exposed, and the portions of the external connection terminal 12 other than its distal end portion and the entire surface of the electrode terminal formation surface are covered with the insulating resin 30 in the way described above.

In the semiconductor device so fabricated, the external connection terminal 12 is covered with the insulating resin 30 and is therefore supported in a reinforcement. Because the insulating resin 30 has a predetermined flexibility, it does not restrict flexibility of the external connection terminal 12, but can appropriately mitigate thermal stress during the packaging process of the semiconductor device.

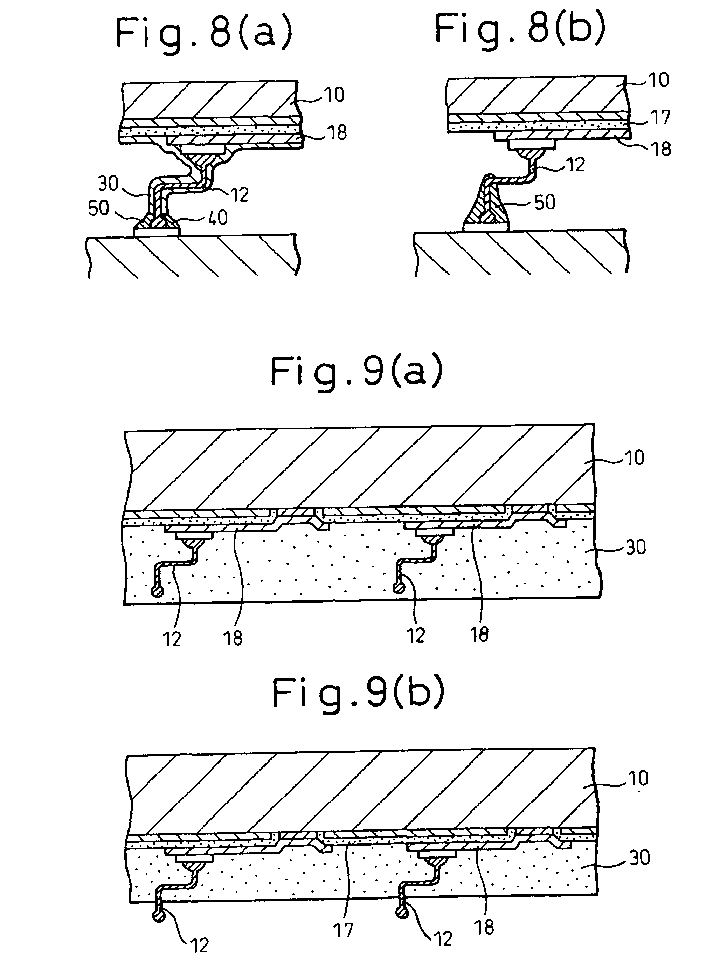

In the semiconductor device according to this embodiment, solder wettability at the time of packaging can be adjusted by adjusting the exposure distance of the distal end portion of the external connection terminal 12. When the outer surface of the external connection terminal 12 is covered with the insulating resin 30 as shown in Fig. 8(a), creep-up of the solder 50 can be checked at the portion at which the insulating resin 30 is disposed. The solder 50 may be formed beforehand on the distal end of the external connection terminal 12 and, otherwise, may be formed beforehand on a terminal portion of the mounting board. Fig. 8(b) shows the state where the external connection terminal 12 is not covered with the insulating resin 30 and creep-up of the solder 50 occurs.

Fig. 9 shows an embodiment wherein the electrode terminal formation surface of the semiconductor chip 10 is covered with the insulating resin 30 in such a fashion that the external connection terminal 12 is buried.

Fig. 9(a) shows the state where the electrode terminal formation surface of the semiconductor element 10 is covered with the insulating resin 30 and the external connection terminal 12 is covered also with the insulating resin 30. The external connection terminal 12 is solely formed of the gold wire in the same way as in the embodiment described above. Spin coating, for example, can be used for covering the external connection terminal 12 with the insulating resin 30 in such a fashion as to bury the external connection terminal 12.

As shown in Fig. 9(b), after the electrode terminal formation surface of the semiconductor element 10 is covered with the insulating resin 30, the outer surface of the insulating resin 30 is immersed in the peeling solution of the insulating resin 30. In this way, only the distal end portion of the external connection terminal 12 can be exposed from the surface of the insulating resin 30.

In the method of fabricating the semiconductor device according to the present invention, the method of covering the electrode terminal formation surface of the semiconductor element 10 with the insulating resin 30 in the liquid form, etc, or the method of covering the outer surface of the external connection terminal 12, is easy to carry out. Therefore, the electrode terminal formation surface of the semiconductor chip 10 can be covered easily with the insulation resin 30.

The method of fabricating the semiconductor device according to the present invention can be applied to a case where the discrete semiconductor chip is the workpiece and to a case where a semiconductor wafer is the workpiece, and can employ an efficient fabrication process. When the semiconductor wafer is the workpiece, the electrode terminal formation surface is covered with the insulating resin 30 while the external connection terminal 12 is fitted to the electrode terminal formation surface of the semiconductor wafer. Thereafter, the semiconductor wafer is sliced into the discrete semiconductor devices.

Each of the embodiments described above uses such a structure in which the re-wiring portion 18 is disposed on the electrode terminal formation surface of the semiconductor chip 10 and the external connection terminal 12 is connected to the re-wiring portion 18. However, the external connection terminal 12 can be formed in such a fashion as to be connected to the electrode terminal 14 itself without disposing the re-wiring portion on the electrode terminal formation surface 18.

A UV-curable resin can be used for the insulating resin 30. In this case, after the electrode terminal formation surface is covered with the insulating resin 30, the ultra-violet rays are irradiated to the insulating resin 30 to cure it.

In the semiconductor device according to the present invention, the re-wiring portion formed on the electrode terminal formation surface of the semiconductor chip is covered with the insulating resin. Thereafter, when the semiconductor chip is packaged, the semiconductor device is free from the problem that electrical short-circuits occur between the lead wires and that migration develops. Since the material having a predetermined buffer property is used for the insulating resin covering the re-wiring portion, the thermal stress occurring between the packaging substrate and the semiconductor chip during packaging can be effectively mitigated, and a semiconductor device having high reliability can be obtained.

According to the method of fabricating the semiconductor device of the present invention, the electrode terminal formation surface of the semiconductor chip can be covered easily with the insulating resin, and a semiconductor device that has high reliability and can be easily handled during packaging can be obtained.

## Claims

1. A semiconductor device comprising:
a semiconductor element (10) having an electrode formation surface on which at least one electrode terminal (14) and a re-wiring portion (18) are formed, said re-wiring portion (18) electrically connected to said electrode terminal (14);
an external terminal (12) made of wire having a base end connected to said re-wiring portion (18) and a distal end extending therefrom; and
electrically insulating resin (30) covering said electrode formation surface, at least said one electrode terminal (14), said re-wiring portion (18) and a part of said external terminal (12) in such a manner that at least said distal end of the external terminal (12) is exposed out of said insulating resin.

2. A semiconductor device as set forth in claim 1, wherein said external terminal (12) is connected to said rewiring portion (18) by wire-bonding and has a substantially L-shape at an intermediate position thereof between said base and distal ends thereof.

3. A process for fabricating a semiconductor device comprising a semiconductor element (10) having an electrode formation surface on which at least one electrode terminal (14) and a re-wiring portion (18) are formed, said re-wiring portion (18) electrically connected to said electrode terminal (14); said process comprising the following steps of:
bonding one end of a wire to said rewiring portion (18) to form an external connecting terminal (12) in such a manner that said external connecting terminal (12) extends from and is supported by said re-wiring portion (18);
coating said electrode formation surface, at least said one electrode terminal (14), said re-wiring portion (18) and an outer surface of said external connecting terminal with an electrically insulating resin (30); and
removing a part of said electrically insulating resin (30) from a distal end of said external connecting terminal (12) to expose the same from the insulating resin (30).

4. A process as set forth in claim 3, wherein, during the bonding process, said one end of the wire is first bonded to said re-wiring portion (18) and then a substantially L-shape portion is formed at an intermediate position thereof.

5. A process as set forth in claim 3 or 4, wherein said electrode formation surface is coated with electrically insulating resin (30) by spin-coating or spray-coating.

6. A process as set forth in claim 3 or 4, wherein said electrode formation surface is coated with electrically insulating resin (30) by dipping said semiconductor element (10) together with said external connecting terminal (12) in liquid insulating resin.

7. A process as set forth in any one of claims 3 to 6, wherein:
said electrode formation surface of the semiconductor element (10) is coated with an electrically insulating resin (30) to such a depth that said external connecting terminal (12) is buried within said insulating resin (30); and then
a part of said electrically insulating resin (30) is removed so that said distal end of said external connecting terminal (12) is exposed from the insulating resin (30).

8. A process as set forth in claim 7, wherein a part of said electrically insulating resin (30) is removed by etching.

9. A process as set forth in claim 7, wherein a part of said electrically insulating resin (30) is removed by dipping said tip end of said external connecting terminal (12) in a peeling solution.

## Patentansprüche

1. Halbleitervorrichtung mit:
einem Halbleiterelement (10), das eine Oberfläche zur Bildung von Elektroden aufweist, auf der wenigstens ein Elektrodenanschluss (14) und ein Neuverdrahtungsbereich (18) ausgebildet sind, wobei der Neuverdrahtungsbereich (18) mit dem Elektrodenanschluss (14) elektrisch verbunden ist;
einem aus einem Draht herstellten externen Anschluss (12), der ein Basisende, das mit dem Neuverdrahtungsbereich (18) verbunden ist, und ein distales Ende aufweist, das sich von diesem erstreckt; und
elektrisch isolierendem Harz (30), der die Oberfläche zur Bildung von Elektroden, dem wenigstens einen Elektrodenanschluss (14), den Neuverdrahtungsbereich (18) und einen Teil des externen Anschlusses (12) derart bedeckt, dass wenigstens das distale Ende des externen Anschlusses (12) außerhalb des isolierenden Harzes freigelegt ist.

2. Halbleitervorrichtung nach Anspruch 1, bei der der externe Anschluss (12) mit dem Neuverdrahtungsbereich (18) durch Drahtbonden verbunden ist und an einer dazwischen liegenden Stelle desselben zwischen den Basis- und distalen Enden desselben eine im wesentlichen L-Form aufweist.

3. Verfahren zum Herstellen einer Halbleitervorrichtung mit einem Halbleiterelement (10), das eine Oberfläche zur Bildung von Elektroden aufweist, auf der wenigstens ein Elektrodenanschluss (14) und ein Neuverdrahtungsbereich (18) ausgebildet sind, wobei der Neuverdrahtungsbereich (18) mit dem Elektrodenanschluss (14) elektrisch verbunden ist, wobei das Verfahren die folgenden Schritte umfasst:
Bondieren eines Endes eines Drahts an den Neuverdrahtungsbereich (18), um einen externen Verbindungsanschluss (12) derart herzustellen, dass sich der externe Verbindungsanschluss (12) von dem Neuverdrahtungsbereich (18) erstreckt und von dem Neuverdrahtungsbereich (18) abgestützt ist;
Beschichten der Oberfläche zur Bildung von Elektroden, des wenigstens einen Elektrodenanschlusses (14), des Neuverdrahtungsbereichs (18) und einer äußeren Oberfläche des externern Verbindungsanschlusses mit einem elektrisch isolierenden Harz (30); und
Entfernen eines Teils des elektrisch isolierenden Harzes (30) von einem distalen Ende des externen Verbindungsanschlusses (12), um diesen von dem isolierenden Harz (30) freizulegen.

4. Verfahren nach Anspruch 3, bei dem während des Bondierungsverfahrens das eine Ende des Drahts zuerst an den Neuverdrahtungsbereich (18) bondiert wird und dann ein im wesentlichen L-förmiger Teil an einer dazwischen liegenden Stelle desselben ausgebildet wird.

5. Verfahren nach Anspruch 3 oder 4, bei dem die Oberfläche zur Bildung von Elektroden mit elektrisch isolierendem Harz (30) durch Schleuderbeschichten oder Sprühbeschichten beschichtet wird.

6. Verfahren nach Anspruch 3 oder 4, bei dem die Oberfläche zur Bildung von Elektroden mit elektrisch isolierendem Harz (30) beschichtet wird, indem das Halbleiterelement (10) zusammen mit dem externen Verbindungsanschluss (12) in ein flüssiges isolierendes Harz getaucht wird.

7. Verfahren nach einem der Ansprüche 3 bis 6, bei dem:
die Oberfläche zur Bildung von Elektroden des Halbleiterelements (10) mit einem elektrisch isolierenden Harz (30) derart beschichtet wird, dass eine Tiefe des externen Verbindungsanschlusses (12) in dem isolierenden Harz (30) begraben ist; und dann
ein Teil des elektrischen isolierenden Harzes (30) so entfernt wird, dass das distale Ende des externen Verbindungsanschlusses (12) von dem isolierenden Harz (30) freigelegt wird.

8. Verfahren nach Anspruch 7, bei dem ein Teil des elektrisch isolierenden Harzes (30) durch Ätzen entfernt wird.

9. Verfahren nach Anspruch 7, bei dem ein Teil des elektrisch isolierenden Harzes (30) entfernt wird, indem die Endspitze des externen Verbindungsanschlusses (12) in eine Schällösung getaucht wird.

## Revendications

1. Dispositif à semi-conducteur, comprenant :
un élément en semi-conducteur (10) comportant une surface de formation d'électrode, sur laquelle au moins une borne d'électrode (14) et une partie recâblage (18) sont formées, ladite partie recâblage (18) étant électriquement reliée à ladite borne d'électrode (14) ;
une borne externe (12) faite en un fil métallique ayant une extrémité de base, qui est reliée à ladite partie recâblage (18), et une extrémité distale s'étendant à partir d'elle ; et
une résine électriquement isolante (30), recouvrant ladite surface de formation d'électrode, au moins ladite borne d'électrode (14), ladite partie recâblage (18) et une partie de ladite borne externe (12) de telle manière qu'au moins ladite extrémité distale de la borne externe (12) soit exposée à l'extérieur de ladite résine isolante.

2. Dispositif à semi-conducteur selon la revendication 1, dans lequel ladite borne externe (12) est reliée à ladite partie recâblage (18) par soudage des fils, et présente une forme sensiblement en L en un emplacement intermédiaire entre ses extrémités de base et distale.

3. Procédé de fabrication d'un dispositif à semi-conducteur, comprenant un élément en semi-conducteur (10) comportant une surface de formation d'électrode, sur laquelle au moins une borne d'électrode (14) et une partie recâblage (18) sont formées, ladite partie recâblage (18) étant électriquement reliée à ladite borne d'électrode (14) ; ledit procédé comprenant les étapes de :
fixation d'une extrémité d'un fil métallique à ladite partie recâblage (18) pour former une borne de connexion externe (12), de telle manière que ladite borne de connexion externe (12) s'étende à partir de ladite partie recâblage (18) et soit soutenue par celle-ci ;
revêtement de ladite surface de formation d'électrode, au moins de ladite borne d'électrode (14), de ladite partie recâblage (18) et d'une surface extérieure de ladite borne de connexion externe, par une résine électriquement isolante (30) ; et
élimination d'une partie de ladite résine électriquement isolante (30), sur une extrémité distale de ladite borne de connexion externe (12) afin de dégager de la résine isolante (30).

4. Procédé selon la revendication 3, dans lequel, pendant le processus de fixation, ladite extrémité du fil métallique est d'abord fixée sur ladite partie recâblage (18) et, ensuite, une partie sensiblement en L est formée en un emplacement intermédiaire de ce fil.

5. Procédé selon la revendication 3 ou 4, dans lequel ladite surface de formation d'électrode est revêtue de résine électriquement isolante (30) par une opération de revêtement par centrifugation ou de revêtement par projection.

6. Procédé selon la revendication 3 ou 4, dans lequel ladite surface de formation d'électrode est revêtue de résine électriquement isolante (30) par trempage dudit élément en semi-conducteur (10) ainsi que de ladite borne de connexion externe (12) dans une résine isolante à l'état liquide.

7. Procédé selon l'une quelconque des revendications 3 à 6, dans lequel :
ladite surface de formation d'électrode de l'élément en semi-conducteur (10) est revêtue d'une résine électriquement isolante (30), sur une profondeur telle que ladite borne de connexion externe (12) soit enterrée à l'intérieur de ladite résine isolante (30) ; et ensuite
une partie de ladite résine électriquement isolante (30) est éliminée, de telle manière que ladite extrémité distale de ladite borne de connexion externe (12) soit dégagée de la résine isolante (30).

8. Procédé selon la revendication 7, dans lequel une partie de ladite résine électriquement isolante (30) est éliminée par attaque chimique.

9. Procédé selon la revendication 7, dans lequel une partie de ladite résine électriquement isolante (30) est éliminée par trempage de ladite extrémité de bout de ladite borne de connexion externe (12), dans une solution de pelage.
